Europäisches Patentamt

European Patent Office

Office européen des brevets

(19)

(11)  EP 0 530 052 B1

(12)  EUROPEAN PATENT SPECIFICATION

(45) Date of publication and mention
of the grant of the patent:
**28.02.1996  Bulletin 1996/09**

(51) Int Cl.6: **H01G 4/30**, H05K 3/46,
H01L 41/08

(21) Application number: **92307906.5**

(22) Date of filing: **01.09.1992**

(54) **Method of manufacturing multilayer electronic component**

Herstellungsverfahren von einem elektronischen Vielschichtbauelement

Méthode de fabrication d'un composant électronique multicouche

(84) Designated Contracting States:
**DE FR GB**

(30) Priority: **30.08.1991 JP 219842/91**

(43) Date of publication of application:
**03.03.1993  Bulletin 1993/09**

(73) Proprietor: **MURATA MANUFACTURING CO.,
LTD.
Nagaokakyo-shi,Kyoto (JP)**

(72) Inventors:
- **Takaoka, Tatsuru, c/o Murata Manuf. Co., Ltd.
  Nagaokakyo-shi, Kyoto (JP)**
- **Yagi, Kouichi, c/o Murata Manuf. Co., Ltd.
  Nagaokakyo-shi, Kyoto (JP)**
- **Kohno, Yoshiaki, c/o Murata Manuf. Co., Ltd.
  Nagaokakyo-shi, Kyoto (JP)**

(74) Representative: **Milhench, Howard Leslie et al
R.G.C. Jenkins & Co.
26 Caxton Street
London SW1H 0RJ (GB)**

(56) References cited:
EP-A- 0 146 036         EP-A- 0 362 404
EP-A- 0 381 879         DE-A- 3 941 346

**Description**

BACKGROUND OF THE INVENTION

The present invention relates to a method of and apparatus for manufacturing a multilayer electronic component.

Multilayer electronic components are typically represented by multilayer ceramic electronic components, such as a multilayer ceramic capacitor, a multilayer ceramic substrate, a multilayer varistor, a multilayer piezoelectric element and the like. In addition to the multilayer ceramic electronic components, the multilayer electronic components include a multilayer film electronic component such as a multilayer film capacitor, which is made of an organic film.

Japanese Patent Laying-Open No. 1-226131 (1989) describes a method of manufacturing a multilayer ceramic electronic component, which is of interest to the present invention. This literature discloses a method of manufacturing a multilayer ceramic capacitor, for example, which comprises the steps of forming patterned electrodes on a carrier film and forming a ceramic green sheet thereon so that the electrodes are embedded in the ceramic green sheet. The method further comprises the steps of thermocompression-bonding the ceramic green sheet on to another ceramic green sheet or other electrodes and separating the carrier film thereby transferring the former onto the latter.

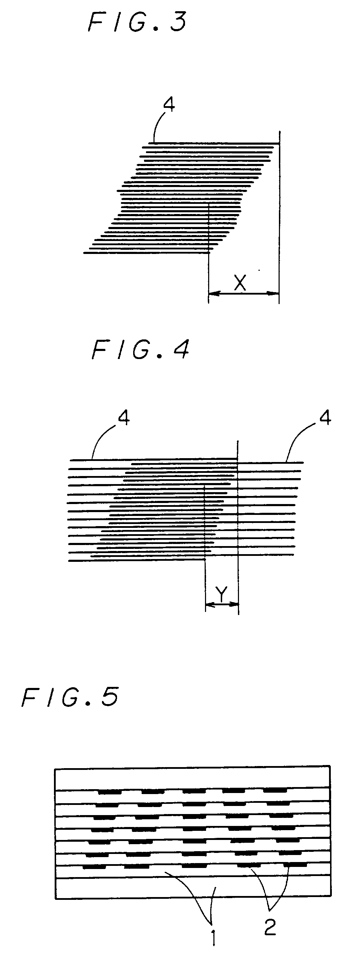

When such ceramic green sheets are reduced in thickness and increased in number of layers in order to increase the capacitance and reduce the size of the multilayer ceramic capacitor obtained with application of the aforementioned method, however, electrodes, i.e., internal electrodes are extremely misregistered from each other, as the result of the pressurization of the ceramic green sheets. Fig. 5 shows an example of such misregistration of internal electrodes. Referring to Fig. 5, ceramic green sheets 1 provided with internal electrodes 2 are stacked with each other.

When such misregistration takes place, the internal electrodes 2 may be exposed on undesired portions in a later cutting step, or the as-formed multilayer ceramic capacitor may be insufficient in capacitance.

EP-A-146,036 was cited by the European Patent Office during examination. The citation describes a method of forming a multilayer ceramic substrate from a large area green sheet. The described method comprises aligning individual layer sites on the large green sheet with respect to a die cavity and then punching the aligned sites to form a stack of layers. Once formed, the stack is laminated and sintered to form the substrate.

EP-A-362404 was also cited by the European Patent Office during examination. This citation describes a method of producing laminated ceramic electronic parts. Pressure is applied to an electrode-embedded green ceramic sheet pre-formed on a support member to attach the same to another green sheet or an electrode. Then the support member is peeled off and the electrode-embedded green ceramic sheet is laminated to the other green sheet.

DE-A-3941346 was also cited by the European Patent Office during examination. This citation describes a method of fabricating a multilayer capacitor, in which method portions are cut from a ceramic green sheet on a carrier by way of a cutting head. The cutting head includes a vacuum pick up which is used to pick up the cut portion and place it in a mold together with other cut portions for pressing.

SUMMARY OF THE INVENTION

The present invention aims to provide a method of and apparatus for manufacturing a multilayer electronic component, which can solve the aforementioned problems.

In one aspect the present invention provides a method of manufacturing a multilayer electronic component, the method comprising: preparing a mother sheet with a patterned electrode layer thereon on a carrier; placing the carrier between a punch and a frame having inner dimensions suitable for stacking a plurality of sheets; and repeatedly moving the carrier to place a section of the mother sheet between the frame and the punch, moving the punch to the frame such that a sheet section is cut from the mother sheet by edges of the frame, is stacked within the frame, and is compression bonded with previously cut sheets within the frame, and separating the carrier from the stacked sheets.

In another aspect the present invention provides an apparatus for manufacturing a multilayer electronic component, the apparatus comprising: a frame having inner dimensions suitable for stacking a plurality of sheets; a stacking table or supporting said frame and said plurality of sheets; a punch movable towards the frame; means for moving a carrier having a mother sheet with a patterned electrode layer thereon between the punch and the frame, the apparatus being arranged such that when, in use, the punch is repeatedly moved towards the frame with intermittent movement of the carrier, sections of the mother sheet are cut along the inner edges of the frame and are stacked and compression-bonded with each other between the stacking table and the punch within the frame, and the carrier is separated from the stacked sheets.

Thus, in the practice of the present invention, the sheets obtained by cutting the mother sheet are regulated by the frame to be successively stacked with each other in the frame by transfer and to be pressurized in the frame, whereby no misregistration is caused in the plurality of conductor films. This makes is possible to prevent misregistration of electrodes etc. which may be caused by the pressurization of the sheets. When applied to the manufacture of a multilayer ceramic capacitor, therefore, it is possible to prevent undesirable exposure of internal electrodes as well as insufficiency in capacitance, thereby obtaining a miniature multilayer ceramic capacitor having high capacitance.

Particularly when the mother sheet is cut along inner edges of the frame to obtain the respective ones of the plurality of sheets and the sheets are regulated by the frame to be successively stacked with each other in the frame by transfer, it is possible to eliminate factors causing misregistration of the sheets during the stacking step. As a result, it is further possible to prevent misregistrations of the conductor films which may be caused by such misregistration of the sheets.

The above and further features of the present invention are set forth with particularity in the appended claims and the same together with further advantages will become clear from consideration of the following detailed description of exemplary embodiments of the present invention given with reference to the accompanying drawings.

## BRIEF DESCRIPTION OF THE DRAWINGS

Figs. 1(A) to 1(E) are illustrative sectional views showing a method of manufacturing a multilayer ceramic capacitor embodying the present invention;

Figs. 2(A) to 2(F) are illustrative sectional views showing another method of manufacturing a multilayer ceramic capacitor embodying the present invention;

Fig. 3 is a sectional view showing misregistration of internal electrodes 4 when using cross-directional stacking;

Fig. 4 is a sectional view showing misregistration of internal electrodes 4 when using longitudinal stacking; and

Fig. 5 is an illustrative section view showing misregistration of internal electrodes 2.

## DETAILED DESCRIPTION OF THE EMBODIMENTS

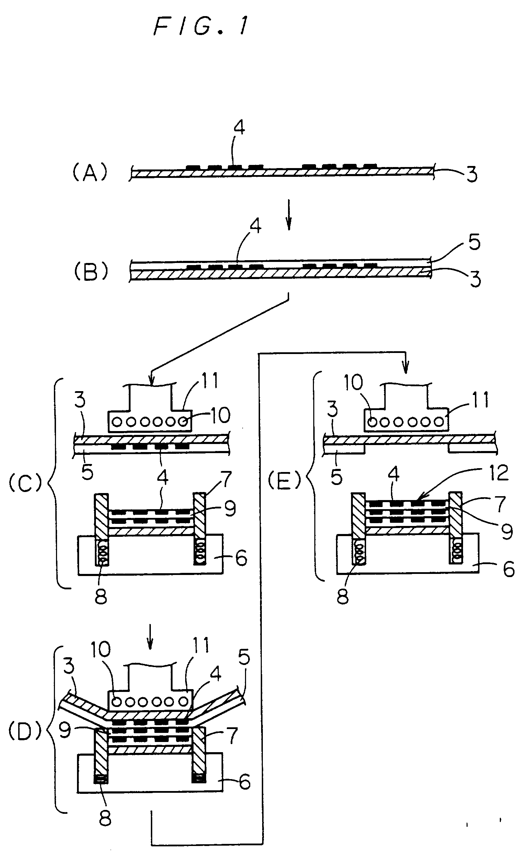

Figs. 1(A) to 1(E) illustrate an embodiment of the present invention.

Referring to Fig. 1(A), paste containing Ag-Pd, Pt, Ni or Ag is screen-printed onto a carrier film 3 of polyethylene terephthalate, for example, for serving as a base, thereby forming patterned internal electrodes 4. The internal electrodes 4 are dried at a temperature of 50 to 200°C, for example. Such internal electrodes 4 may alternatively be formed by a method of vapor deposition or sputtering as described in U. S. Patent No. 5,009,744, for example.

Then, a ceramic green sheet 5 is formed on the carrier film 3, as shown in Fig. 1(B). At this time, the internal electrodes 4 are embedded in the ceramic green sheet 5. The ceramic green sheet 5 is prepared by sheet-forming dielectric ceramic slurry which contains 10 to 20 percent by weight of thermoplastic resin such as butyral resin, for example.

Then, the ceramic green sheet 5 which is held by the carrier film 3 is arranged to face a stacking table 6, as shown in Fig. 1(C). The stacking table 6 comprises a vertically movably held frame 7, which is upwardly urged by a spring 8. This frame 7 has inner dimensions capable of locating sheets 9 to be stacked therein. A punch 11 containing a heater 10 is arranged above the ceramic green sheet 5 and the carrier film 3.

Then, the punch 11 is downwardly moved so that the ceramic green sheet 5 is thermocompression-bonded toward the uppermost one of the sheets 9, which have already been stacked, as shown in Fig. 1(D). At this time, the frame 7 is downwardly moved against elasticity of the spring 8. The ceramic green sheet 5, which is adapted to serve as a mother sheet for providing each sheet 9, is cut along inner edges of the frame 7, so that the sheet 9 is taken out from the ceramic green sheet 5. The inner edges of the frame 7 may be knife-edged. According to this embodiment, the inner edges of the frame 7 themselves serve as cutting edges, while cutting edges may be provided independently of the frame 7. In the step shown in Fig 1(D), the ceramic green sheet 5 is brought into pressure contact with the uppermost one of the stacked sheets 9 at a temperature of 30 to 100°C under a pressure of 50 to 250 kg/cm$^2$, for example.

Then, the punch 11 is returned to its original position, as shown in Fig. 1(E). In response to this, the carrier film 3 is also upwardly moved to be separated from the sheet 9 which is taken out from the ceramic green sheet 5, while the sheet 9 thus taken out from the ceramic green sheet 5 is stacked on the upmost one of those already stacked in the frame 7 by transfer.

A layered product 12 obtained in the aforementioned manner is further cut to define chips for forming multilayer ceramic capacitors respectively. Then each chip is fired and provided with external electrodes, to obtain desired multilayer ceramic capacitors.

The inventive method as described above and the method described in the aforementioned literature, being similar to the inventive method except that no frame 7 is employed, were carried out to make a comparison/evaluation test. In this test, internal electrodes were designed to have pattern dimensions of 1.70 by 1.05 [mm$^2$] after firing in the step shown in Fig. 1(E).

Table 1 shows values of misregistration caused in 50 layers and 100 layers of the internal electrodes. Referring to Table 1, columns of "direction W" show values of cross-directional misregistration X of the internal electrodes 4 as shown in Fig. 3, and those of "direction L" show values of longitudinal misregistration Y of the internal electrodes 4 as shown in Fig. 4.

Table 1

| | Conventional Method | | Inventive Method | |
|---|---|---|---|---|
| | Direction W | Direction L | Direction W | Direction L |
| 50 Layers $\bar{x}$ [μm] | 150 | 125 | 35 | 24 |
| 3CV | 52.4 | 25.0 | 5.8 | 2.3 |
| 100 Layers $\bar{x}$ [μm] | 380 | 282 | 53 | 27 |
| 3CV | 62.4 | 28.0 | 7.2 | 3.8 |

$$[3CV = 3\sigma/\bar{x} \times 100]$$

According to the present invention, it is possible to suppress misregistration by about 80 percent as compared with the conventional method in each case of 50 layers and 100 layers, as understood from Table 1.

On the other hand, Table 2 shows cutting defective rates and capacitance values of chips obtained by cutting layered products, each of which was formed by 100 layers of internal electrodes.

Table 2

| | Conventional Method | Inventive Method |
|---|---|---|
| Cutting Defective Rate | 38.0% | 0% |
| Capacitance $\bar{x}$ [μF] | 0.91 | 1.08 |
| 3CV | 25.3 | 5.2 |

As understood from Table 2, the conventional method exhibited a cutting defective rate of 38.0 percent, while the inventive method caused absolutely no cutting defective. It is also understood that higher capacitance can be attained in the present invention as compared with the conventional method, with smaller dispersion.

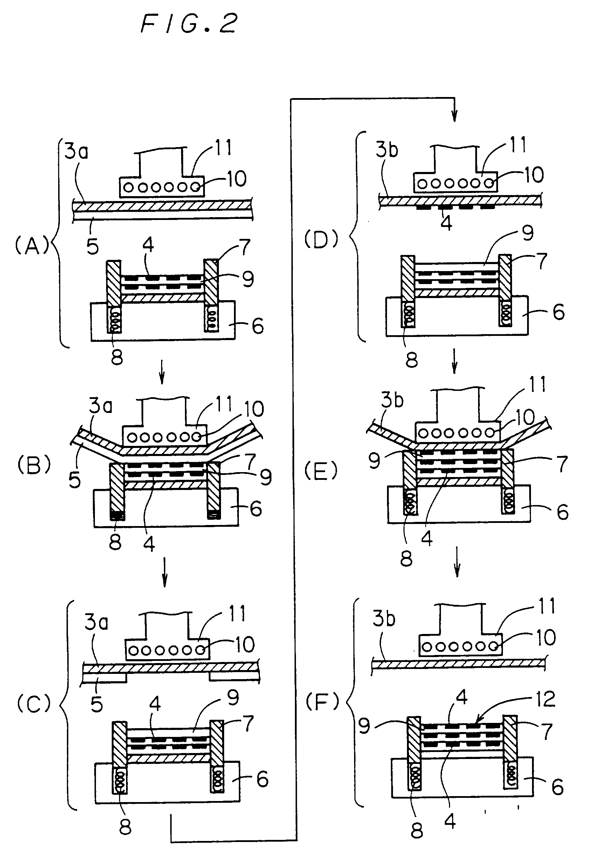

Figs. 2(A) to 2(F) illustrate another embodiment of the present invention. Referring to Figs. 2(A) to 2(F), elements corresponding to those shown in Figs. 1(A) to 1(E) are denoted by similar reference numerals, to omit redundant description. This embodiment is adapted to obtain a layered product by alternately transferring ceramic green sheets and internal electrodes.

Referring to Fig. 2(A), a ceramic green sheet 5 which is held by a carrier film 3a is arranged between a stacking table 6 and a punch 11. No internal electrodes are embedded in this ceramic green sheet 5.

Then, the ceramic green sheet 5 is thermocompression-bonded toward the uppermost one of sheets 9 which have already been stacked, as shown in Fig. 2(B). At the same time, the ceramic green sheet 5 is cut along inner edges of a frame 7.

Then, the as-formed sheet 9 is separated from the carrier film 3a, as shown in Fig. 2(C).

Then, internal electrodes 4 which are held on another carrier film 3b are arranged between the stacking table 6 and the punch 11, as shown in Fig. 2(D).

Then, the internal electrodes 4 are thermocompression-bonded toward the uppermost one of the already stacked sheets 9, as shown in Fig. 2(E). At this time, the internal electrodes 4 are embedded in the uppermost sheet 9.

Then, the internal electrodes 4 are separated from the carrier film 3b, as shown in Fig. 2(F).

Thus, the plurality of sheets 9 and the plurality of internal electrodes 4 are successively alternately stacked in the frame 7 by transfer and pressurized in the frame 7, to obtain a layered product 12 similarly to the embodiment shown in Figs. 1(A) to 1(E).

Although the present invention has been described in relation to a method of manufacturing a multilayer ceramic capacitor, the present invention can also be applied to general multilayer electronic components such as multilayer ceramic electronic components including a multilayer ceramic substrate, a multilayer varistor, a multilayer piezoelectric element and the like, a multilayer film electronic component such as a multilayer film capacitor being made of an organic film, and the like.

The carrier film employed as a base in each of the aforementioned embodiments may be replaced by a roll.

Although the present invention has been described and illustrated in detail, it is to be clearly understood that the same is by way of illustration and example only and is not to be taken by way of limitation, the scope of the present invention being limited only by the terms of the appended claims.

## Claims

1. A method of manufacturing a multilayer electronic component, the method comprising:

   preparing a mother sheet with a patterned electrode layer thereon on a carrier;
   placing the carrier between a punch and a frame having inner dimensions suitable for stacking a plurality of sheets; and
   repeatedly moving the carrier to place a section of the mother sheet between the frame and the punch, moving the punch to the frame such that a sheet section is cut from the mother sheet by edges of the frame, is stacked within the frame, and is compression bonded with previously cut sheets within the frame, and separating the carrier from the stacked sheets.

2. A method according to claim 1, wherein the mother sheet comprises a ceramic green sheet.

3. A method according to claim 2, further comprising preparing a patterned electrode layer on another carrier and repeatedly moving the other carrier to place a section of the carrier between the frame and the punch so that sections of the electrode layer are stacked between consecutive sheets from the mother sheet.

4. A method according to any preceding claim, further comprising heating the punch so that the sheets are bonded by thermocompression.

5. An apparatus for manufacturing a multilayer electronic component, the apparatus comprising:

   a frame (7) having inner dimensions suitable for stacking a plurality of sheets (9);
   a stacking table (6) for supporting said frame (7) and said plurality of sheets (9);
   a punch (11) movable towards the frame (7);
   means for moving a carrier (3) having a mother sheet (5) with a patterned electrode layer (4) thereon between the punch (11) and the frame (7), the apparatus being arranged such that when, in use, the punch is repeatedly moved towards the frame (7) with intermittent movement of the carrier (3), sections of the mother sheet (5) are cut along the inner edges of the frame (7) and are stacked and compression-bonded with each other between the stacking table and the punch within the frame (7), and the carrier is separated from the stacked sheets.

6. An apparatus according to claim 5, wherein the punch (11) comprises a heater (10) for heating the punch so that the stacked sheets (9) are bonded by thermocompression.

7. An apparatus according to claim 5 or 6, wherein said frame (7) is spring loaded so as to be vertically movable.

8. An apparatus according to any of claims 5 to 7, wherein said frame (7) comprises cutting edges formed at its inner edges.

9. An apparatus according to any of claims 5 to 8, wherein said mother sheet comprises a ceramic green sheet and a patterned electrode layer is provided on another carrier, the positioning means being arranged repeatedly to move the other carrier to place a section thereof between the punch and the frame, and the apparatus being arranged so that sections of the electrode layer are stacked between consecutive sheets from the mother sheet so that the patterns on the sections are aligned.


## Patentansprüche

1. Verfahren zum Herstellen eines elektronischen Vielschichtbauelements, wobei das Verfahren folgendes umfaßt:

   - Herstellen einer Mutterlage mit einer darauf befindlichen gemusterten Elektrodenschicht auf einem Träger;
   - Anordnen des Trägers zwischen einer Stanze und einem Rahmen mit Innenabmessungen, die zum Aufstapeln mehrerer Lagen geeignet sind; und
   - wiederholtes Verstellen des Trägers zum Anordnen eines Abschnitts der Mutterlage zwischen dem Rahmen und der Stanze, Verstellen der Stanze zum Rahmen in solcher Weise hin, daß ein Lagenabschnitt durch die Rahmenkanten aus der Mutterlage ausgeschnitten wird, innerhalb des Rahmens aufgestapelt wird und durch Druck mit zuvor herausgeschnittenen Lagen innerhalb des Rahmens verbunden wird, und Abtrennen des Trägers von den aufgestapelten Lagen.

2. Verfahren nach Anspruch 1, bei dem die Mutterlage aus einer ungebrannten Keramiklage besteht.

3. Verfahren nach Anspruch 2, bei dem ferner eine gemusterte Elektrodenschicht auf einem anderen Träger hergestellt wird und der andere Träge wiederholt so verstellt wird, daß ein Abschnitt des Trägers zwischen dem Rahmen und der Stanze angeordnet wird, so daß Abschnitte der Elektrodenschicht zwischen aufeinanderfolgenden Lagen aus der Mutterlage aufgestapelt werden.

4. Verfahren nach einem der vorstehenden Ansprüche, ferner umfassend das Beheizen der Stanze, damit die Lagen durch Wärme und Druck verbunden werden.

5. Vorrichtung zum Herstellen eines elektronischen Mehrschichtbauelements, wobei die Vorrichtung folgendes aufweist:

- einen Rahmen (7) mit Innenabmessungen, die zum Aufstapeln mehrerer Lagen (9) geeignet sind;
- einen Stapeltisch (6) zum Halten des Rahmens (7) und der mehreren Lagen (9);
- eine Stanze (11), die zum Rahmen (7) hin verstellbar ist;
- eine Einrichtung zum Verstellen eines Trägers (3) mit einer Mutterlage (5) mit einer darauf befindlichen, gemusterten Elektrodenschicht (4) zwischen die Stanze (11) und den Rahmen (7), wobei die Vorrichtung so ausgebildet ist, daß bei ihrem Gebrauch die Stanze wiederholt mit intermittierender Verstellung des Trägers (3) zum Rahmen (7) verstellt wird, Abschnitte der Mutterlage (5) entlang den Innenkanten des Rahmens (7) ausgeschnitten, aufeinandergestapelt und zwischen dem Stapeltisch und der Stanze innerhalb des Rahmens (7) durch Druck miteinander verbunden werden, und der Träger von den aufgestapelten Lagen abgetrennt wird.

6. Vorrichtung nach Anspruch 5, bei der die Stanze (11) einen Heizer (10) aufweist, um die Stanze zu beheizen, damit die aufgestapelten Lagen (9) durch Wärme und Druck verbunden werden.

7. Vorrichtung nach einem der Ansprüche 5 oder 6, bei der der Rahmen (7) so durch eine Feder belastet ist, daß er vertikal verstellbar ist.

8. Vorrichtung nach einem der Ansprüche 5 bis 7, bei der der Rahmen (7) an seinen Innenkanten ausgebildete Schneidkanten aufweist.

9. Vorrichtung nach einem der Ansprüche 5 bis 8, bei der die Mutterlage aus einer ungebrannten Keramiklage besteht und eine Schicht mit einer gemusterten Elektrode auf einem anderen Träger vorhanden ist, wobei die Positioniereinrichtung so ausgebildet ist, daß sie den anderen Träger wiederholt so verstellt, daß ein Abschnitt desselben zwischen der Stanze und dem Rahmen angeordnet wird, und die Vorrichtung so ausgebildet ist, daß Abschnitte der Elektrodenschicht zwischen aufeinanderfolgenden Lagen aus der Mutterlage so aufgestapelt werden, daß die Muster in den Abschnitten ausgerichtet sind.

## Revendications

1. Procédé de fabrication d'un composant électronique multicouche, le procédé comprenant les étapes consistant :

- à préparer sur un support une feuille mère portant sur elle une couche d'électrode définissant un motif ;
- à placer le support entre un poinçon et un bâti ayant des dimensions intérieures adaptées pour permettre l'empilement de plusieurs feuilles ; et
- d'une manière répétée, à déplacer le support pour placer une partie de la feuille mère entre le bâti et le poinçon, à déplacer le poinçon vers le bâti de sorte qu'une partie de la feuille soit découpée de la feuille mère par les bords du bâti, empilée à l'intérieur du bâti, et assemblée par compression avec les feuilles découpées antérieurement situées à l'intérieur du bâti, et à séparer le support des feuilles empilées.

2. Procédé selon la revendication 1, dans lequel la feuille mère comprend une feuille céramique verte.

3. Procédé selon la revendication 2, comprenant en outre l'étape consistant à préparer une couche d'électrode définissant un motif sur un autre support et à déplacer de manière répétée l'autre support pour placer une partie du support entre le bâti et le poinçon de sorte que des parties de la couche d'électrode soient empilées entre des feuilles consécutives provenant de la feuille mère.

4. Procédé selon l'une quelconque des revendications précédentes, consistant en outre à chauffer le poinçon de sorte que les feuilles soient assemblées par thermocompression.

5. Appareil pour fabriquer un composant électronique multicouche, l'appareil comprenant :

un bâti (7) ayant des dimensions intérieures adaptées pour permettre l'empilement de plusieurs feuilles (9) ;
une table d'empilage (6) pour supporter ledit bâti (7) et lesdites feuilles (9) ;
un poinçon (11) déplaçable vers le bâti (7) ;
des moyens pour déplacer un support (3) portant sur lui une feuille mère (5) ayant une couche d'électrode définissant un motif (4), entre le poinçon (11) et le bâti (7), l'appareil étant conçu de telle sorte que, pendant l'utilisation, lorsque le poinçon est déplacé de manière répétée vers le bâti (7) suivant le mouvement intermittent du support (3), des parties de la feuille mère (5) soient découpées le long des bords intérieurs du bâti (7) et empilées et assemblées par compression les unes avec les autres entre la table d'empilage et le poinçon à l'intérieur du bâti (7), et le support est séparé des feuilles empilées.

6. Appareil selon la revendication 5, dans lequel le poinçon (11) comprend un dispositif de chauffage (10) pour chauffer le poinçon de telle sorte que les feuilles empilées (9) soient assemblées par thermocompression.

7. Appareil selon la revendication 5 ou 6, dans lequel ledit bâti (7) est chargé par ressort afin d'être déplaçable verticalement.

8. Appareil selon l'une quelconque des revendications 5 à 7, dans lequel ledit bâti (7) comprend des bords coupants formés à ses bords intérieurs.

9. Appareil selon l'une quelconque des revendications 5 à 8, dans lequel ladite feuille mère comprend une feuille céramique verte, et une couche d'électrode définissant un motif est prévue sur un autre support, les moyens de positionnement étant conçus pour déplacer de manière répétée l'autre support afin de placer une partie de celui-ci entre le poinçon et le bâti, le dispositif étant conçu de sorte que des parties de la couche d'électrode soient empilées entre des feuilles consécutives provenant de la feuille mère afin que les motifs sur les parties soient alignés.

## F I G . 1

# F I G . 2

$FIG.3$

$FIG.4$

$FIG.5$